# EUROPÄISCHE PATENTSCHRIFT

(11) **EP 3 147 216 B1**
(45) Veröffentlichungstag und Bekanntmachung des Hinweises auf die Patenterteilung: **07.08.2019**
(21) Anmeldenummer: 15186476.6
(22) Anmeldetag: 23.09.2015
(51) Int. Cl.: B64D 15/12, H05B 3/14, B05D 1/22, B05D 3/02, C23C 16/02, C23C 16/32, C23C 16/34, C23C 16/38, C23C 16/40, C23C 16/44, H05B 3/22

(54) **ELEKTRISCHE ENTEISUNG FÜR LUFTFAHRZEUGE**
ELECTRICAL DE-ICING FOR AIRCRAFT
DEGIVRAGE ELECTRIQUE POUR AVIONS

(43) Veröffentlichungstag der Anmeldung: 29.03.2017
(73) Patentinhaber: Airbus Defence and Space GmbH, 85521 Ottobrunn (DE)
(72) Erfinder: Steinwandel, Dr. rer. nat. Jürgen, 85521 Ottobrunn (DE); Jonke, Dietrich, 85521 Ottobrunn (DE); Piringer, Helmut, 85521 Ottobrunn (DE)
(74) Vertreter: Isarpatent

(56) Entgegenhaltungen:
- DE-A1- 2 628 731
- US-A- 1 868 468
- US-A- 5 316 851
- US-A- 5 934 617
- US-A- 5 947 418
- US-A- 6 031 214
- US-A1- 2011 024 409
- US-A1- 2014 224 782

## Beschreibung

Die vorliegende Erfindung betrifft ein Heizelement zur Flugenteisung von Luftfahrzeugen, ein Heizgerät zur Flugenteisung von Luftfahrzeugen, ein Verfahren zum Herstellen eines Heizelements zur Flugenteisung von Luftfahrzeugen und ein Verfahren zum Enteisen einer Komponente eines Luftfahrzeugs.

Eis und Schnee an Luftfahrzeugen stellen in der Luftfahrt ein bedeutendes Sicherheitsproblem dar. Sie bewirken beispielsweise eine Erhöhung des Gewichts des Luftfahrzeugs, gegebenenfalls eine Verschlechterung der Aerodynamik und insbesondere Asymmetrien hinsichtlich der Form und der Masse. Dadurch wird nicht nur der Kraftstoffverbrauch erhöht, auch die Steuerbarkeit des Luftfahrzeugs kann stark beeinträchtigt werden, was schwere Unglücke bis hin zu einem Absturz des Luftfahrzeugs zur Folge haben kann.

Sowohl zur Vorbeugung als auch zur Beseitigung bereits vorhandener Gefrierungen werden daher Maßnahmen zur Enteisung vorgenommen. Dabei ist zwischen bodengebundener Enteisung und Flugenteisung zu unterscheiden: Die bodengebundene Enteisung erfolgt unmittelbar vor dem Start eines Luftfahrzeugs und wird meist durch Besprühen vereisungsgefährdeter relevanter Oberflächen des Luftfahrzeugs mit Glykol-Mischungen durchgeführt. Die Flugenteisung hingegen wird während eines Fluges vorgenommen, und sie erfolgt im Allgemeinen aus einem inneren Bereich des Luftfahrzeugs heraus. Nach herkömmlichem Vorgehen wird dabei meist heiße Zapfluft aus den Triebwerkskompressoren in geeignete Hohlräume bzw. Kanäle geleitet, um anliegende Bereiche zu erwärmen und so eine Eisbildung zu verhindern oder bereits entstandenes Eis abzutauen.

Dieses zapfluftbasierte, sogenannte "thermische" Verfahren ist sowohl verfahrens- als auch vorrichtungstechnisch aufwendig: Es erfordert eine hohe Anzahl von Komponenten (wie Absperrventile, Rohre und Verzweigungen, Ansaugstutzten und Druckregler), und der Regelungsaufwand, das Gewicht und der Raumbedarf bei einem derartigen System sind hoch. Darüber hinaus können beispielsweise Faserverbundstrukturen, insbesondere Strukturen, die neben Kohlenstofffasern ein Bindeharz umfassen, nicht mit Zapfluft vom Triebwerkskompressor behandelt werden: Aus dem Triebwerkskompressor abzuleitende Luft weist nämlich im Allgemeinen eine Temperatur von über 200°C auf, die das harzbasierte Material in einem Kontaktbereich mit der heißen Luft schädigen würde.

Neben dem thermischen Verfahren ist eine elektrische Enteisung bekannt. Meist werden dafür dünne Heizdrähte oder eine Heizfolie in das Material ein- oder auf es aufgebracht, und die Heizdrähte bzw. die Heizfolie werden an ein Stromsystem angeschlossen. Damit wird Elektrowärme erzeugt, die die Eisbildung verhindert und/oder vorhandenes Eis schmelzt. Dieses Vorgehen hat jedoch einen schlechten Wirkungsgrad, so dass ein hoher Energieaufwand erforderlich ist. Aus diesem Grunde wird es meist nur für Sichtfenster, insbesondere Windschutzscheiben am Cockpit eingesetzt.

US 6031214 beschreibt eine Isolationsschicht, welche aus Glasfasern hergestellt ist. Des Weiteren umfasst das Mischgewebe Rovings mit in longitudinaler und transversaler Richtung verlaufenden isolierenden Glasfasern.

DE 26 28 731 beschreibt ein Heizelement, wobei eine dünne elektrische Isolierschicht integraler Bestandteil des Heizelements ist und diese zwischen den Heizwiderständen und dem die Widerstände umgebende Trägermaterial angeordnet ist.

US 5947418 offenbart eine Heizmatte, deren Glasfasergewebe einen guten elektrischen Kontakt zwischen den metallischen Umhüllungen und den entsprechenden Widerstandselementen sicherstellt. Das isolierende Gewebe weist mehrere übereinanderliegende Schichten aus Glasfasergewebe auf, welche die Widerstandselemente voneinander isoliert und in Position hält.

Die vorliegende Erfindung hat die Aufgabe, eine verfahrens- und vorrichtungstechnisch einfache Flugenteisung zu ermöglichen.

Die Aufgabe wird gelöst durch ein Heizelement gemäß Anspruch 1, ein Verfahren zum Herstellen eines Heizelements gemäß Anspruch 11 und ein Verfahren zum Enteisen einer Komponente eines Luftfahrzeugs gemäß Anspruch 15. Vorteilhafte Ausführungsformen sind in den Unteransprüchen, der Beschreibung und den Figuren offenbart.

Ein erfindungsgemäßes Heizelement umfasst ein Kohlefasermaterial, das (insbesondere hinsichtlich seiner Form) dazu eingerichtet ist, an einer Komponente eines Luftfahrzeugs (z.B. eines Flugzeugs) angeordnet zu werden (beispielsweise indem es an eine Kontur der Komponente des Luftfahrzeugs angepasst und/oder in eine Aushöhlung der Komponente eingepasst ist). Das Kohlefasermaterial weist dabei mindestens zwei elektrische Kontakte zum Anschluss an ein elektrisches Leitungssystem sowie mindestens eine Isolationsschicht zur elektrischen Isolierung auf.

Ein derartiges elektrisch zu betreibendes Heizelement kann mit geringem Steuerungsaufwand und kurzen Ansprechzeiten aktiviert und kontrolliert werden. Insbesondere erlaubt es einen Verzicht auf ein komplexes Luftführungssystem. Darüber hinaus benötigt es wenig Raum und hat ein relativ geringes Gewicht. Dadurch kann gegenüber herkömmlichen, zapfluftbasierten Enteisungsvorrichtungen der Kraftstoffverbrauch des Luftfahrzeugs reduziert werden. Schließlich ermöglicht die Verwendung von Kohlefasermaterial eine gute Formbarkeit, so dass das Heizelement auf einfache Weise passend geformt und in ein bestehendes Bauteil eingebaut werden kann. Die Komponente des Luftfahrzeugs kann beispielsweise eine Flügelinnenverkleidung, eine Anströmkante, eine Triebwerksverkleidung oder einen Triebwerkseinlauf umfassen. Sie kann insbesondere eine metallische und/oder eine Verbundstruktur aus metallischen Anteilen sowie Anteilen aus kohlenstofffaserverstärktem Kohlenstoff umfassen (z.B. beispielsweise eine Flügelstruktur, die aus kohlenstofffaserverstärktem Kohlenstoff mit einer metallischen Vorderkante gefertigt ist).

Das elektrische Leitungssystem kann insbesondere eine (vorzugsweise steuerbare) Spannungsquelle umfassen.

Bei einer (bestimmungsgemäßen) Anordnung an der Komponente kann das Heizelement die Komponente berühren, es kann dabei aber auch in einem Abstand zur Komponente positioniert sein. Im letzteren Falle sind Heizelement und Komponente vorzugsweise in einem so geringen Abstand zueinander angeordnet, dass das Heizelement mindestens einen Abschnitt der Komponente erwärmen kann, beispielsweise in einem Abstand von weniger als 3cm, bevorzugter in einem Abstand kleiner als 1,5 cm.

Mittels der mindestens einen Isolationsschicht zur elektrischen Isolierung (die im Weiteren auch als "elektrische Isolationsschicht" bezeichnet wird) kann das angeordnete Heizelement gegenüber der Komponente elektrisch isoliert werden. Sie kann beispielsweise einen keramischen Werkstoff (wie Aluminiumoxid (Al₂O₃)), Bornitrid (BN), Siliziumkarbid (SiC), Zirkoniumdiborid (ZrB₂) und/oder Hafniumdiborid (HfB₂) enthalten. Erfindungsgemäß ist die mindestens eine Isolationsschicht gasdicht; dadurch kann ein besonders guter Wärmeübergang erzielt werden.

Ein erfindungsgemäßes (Herstellungs-)Verfahren dient einer Herstellung eines Heizelements zur Flugenteisung von Luftfahrzeugen. Es umfasst ein Anbringen von elektrischen Kontakten an ein Kohlefasermaterial und ein Aufbringen einer elektrischen Isolationsschicht auf das Kohlefasermaterial.

Insbesondere können damit ein erfindungsgemäßes Heizelement gemäß einer der in dieser Schrift genannten Ausführungsformen hergestellt und so die entsprechenden Vorteile erzielt werden.

Gemäß einer vorteilhaften Ausgestaltung der vorliegenden Erfindung umfasst die elektrische Isolationsschicht einen keramischen Grundstoff (wie beispielsweise Aluminiumoxid), der als Streichmasse aufgebracht wurde oder wird. Dadurch kann eine Delamination des Kohlefasermaterials bzw. der Isolationsschicht vom Kohlefasermaterial verhindert oder zumindest erschwert werden.

Gemäß einer vorteilhaften Ausführungsform weist ein erfindungsgemäßes Heizelement mindestens einen elektrisch isolierenden Distanzhalter auf, der dazu eingerichtet ist, nach einem Anordnen des Heizelements an der Komponente an mindestens einem Bauteil des Luftfahrzeugs anzuliegen und eine (positiven) Abstand zwischen dem beschichteten Kohlefasermaterial und dem mindestens einen Bauteil zu gewährleisten. Das mindestens eine Bauteil kann dabei die Komponente selbst sein, an der das Heizelement angeordnet wurde, oder es kann ein weiteres Element des Luftfahrzeugs sein, z.B. ein Stütz- und/oder Stabilisationselement in der Komponente.

Sofern der Distanzhalter den Abstand in einem nicht mit einer elektrischen Isolationsschicht versehenen Oberflächenbereich des beschichteten Kohlefasermaterials bewirkt, wird durch ihn eine elektrische Isolierung zwischen dem beschichteten Kohlefasermaterial und dem mindestens einen Bauteil erreicht; andernfalls kann durch ihn die Isolierung bei relativ dünner Isolationsschicht verbessert werden.

Der mindestens eine Distanzhalter kann in Form einer oder mehrerer einzelner Noppen aufgebracht sein und/oder einen Oberflächenbereich des beschichteten Kohlefasermaterials in Form einer Folie abdecken, beispielsweise entlang einem Streifen. Ein derartiger Distanzhalter ist besonders stabil in seiner Position und dabei einfach aufzubringen.

Vorteilhaft ist eine Ausführungsform, bei der der Abstand auch in einer Umgebung des Distanzhalters bewirkt wird, so dass also durch den Distanzhalter mindestens ein (vorzugsweise freier, also luftdurchlässiger) Zwischenraum zwischen dem mindestens einen Bauteil (z.B. zwischen einer Oberfläche der Komponente, an die das Heizelement angesetzt wird oder wurde) und dem beschichteten Kohlefasermaterial gehalten wird. Ein derartiger Zwischenraum ermöglicht eine Luftzirkulation und damit eine gleichmäßige Beheizung.

Der durch den mindestens einen Distanzhalter bewirkte Abstand liegt vorzugsweise in einem Bereich von 0,1 cm bis 3 cm, bevorzugter in einem Bereich von 0,1 cm bis 1,5 cm. Diese Abmessungen gewährleisten einerseits eine konturnahe Anpassung des Heizelements und damit sowohl einen guten Wärmeübergang, als auch einen geringen Raumbedarf des Heizelements, andererseits ist der Abstand groß genug, um gegebenenfalls eine elektrische Isolierung zwischen beschichtetem Kohlefasermaterial und dem mindestens einen Bauteil und/oder eine vorteilhafte Luftzirkulation sicherzustellen.

Vorteilhaft ist eine Ausführungsform, bei der der mindestens eine Distanzhalter eine relativ geringe Wärmeleitfähigkeit aufweist, beispielsweise eine Leitfähigkeit, die kleiner als 35 W/(m·K) oder sogar kleiner als 30 W/(m·K) ist. Insbesondere kann der mindestens eine Distanzhalter ein keramisches Material wie beispielsweise Aluminiumoxid umfassen und/oder einen isolierenden, thermisch beständigen Kunststoff wie z.B. mindestens ein Polyamid und/oder mindestens ein Polyimid (z.B. Kapton).

Derartige Stoffe sind einerseits hitzebeständig, werden also auch bei heißem Heizelement durch den Kontakt mit diesem nicht geschädigt, andererseits sorgt die geringe Wärmeleitfähigkeit für eine Gleichmäßigkeit der Beheizung der Komponente einerseits an der Stelle des Distanzhalters und andererseits an einer Stelle, an der ggf. durch den Distanzhalter zwischen beschichtetem Kohlefasermaterial und dem mindestens einen Bauteil (z.B. der Komponente) ein Zwischenraum erzeugt wird.

Das Kohlefasermaterial kann beispielsweise ein Gewebe oder ein Vlies sein. Die Fasern des Kohlefasermaterials können insbesondere Graphitfasern sein oder Graphitfasern umfassen. Gemäß einer vorteilhaften Ausführungsvariante ist das Kohlefasermaterial mehrlagig und/oder karbonisiert. Dadurch wird jeweils eine besonders hohe mechanische Festigkeit und Formstabilität erreicht. Insbesondere kann das Kohlefasermaterial vorzugsweise ein kohlenstofffaserverstärkter Kohlenstoff sein (für den in der Fachsprache auch die englische Bezeichnung als "carbon-fibre reinforced carbon" (CFC) verwendet wird).

Gemäß einer vorteilhaften Ausführungsform ist das Kohlefasermaterial graphitiert und/oder thermisch behandelt (kalziniert). Ein derartiges Material weist eine große Festigkeit bzw. geringe Porosität auf. Ein erfindungsgemäßes (Herstellungs-)Verfahren gemäß einer vorteilhaften Ausführungsvariante umfasst analog ein Karbonisieren, Graphitieren und/oder Kalzinieren des Kohlefasermaterials.

Vorteilhaft ist eine Ausführungsform eines erfindungsgemäßen Heizelements, bei der zwischen dem Kohlefasermaterial und der mindestens einen elektrischen Isolationsschicht eine Siliziumkarbidschicht angeordnet ist. Eine derartige Siliziumkarbidschicht weist eine vorteilhafte hohe Wärmeleitfähigkeit auf, ist also ein effektiver Heizleiter. Sie bildet eine besonders gute Grundlage für die elektrische Isolationsschicht.

Vorteilhaft ist analog eine Ausführungsform eines erfindungsgemäßen (Herstellungs-)Verfahrens, bei dem das Kohlefasermaterial siliziert wird, beispielsweise durch Aufbringen von flüssigem Silizium. Dadurch wird eine Reaktion mit Kohlenstoff in dem Kohlefasermaterial bewirkt, aus der eine Schicht Siliziumkarbid (SiC) entsteht. Besonders bevorzugt ist eine Variante, bei der vor dem Silizieren des Kohlefasermaterials eine Bearbeitung durch mechanische und/oder plasmatechnische Behandlung erfolgt und/oder eine Bearbeitung mittels Laser und/oder Wasserstrahltechnik. Auf diese Weise kann eine Oberfläche, auf die das flüssige Silizium aufgetragen wird, angeraut und somit die Reaktion und die Schichtbildung bzw. -anhaftung verbessert werden.

Gemäß einer vorteilhaften Ausführungsform umfasst das Kohlefasermaterial ein Kohlefaser-Gittergewebe-Element. Dieses Element kann beispielsweise in eine zwei- oder dreidimensionale Struktur geformt sein, die vorzugsweise an eine Kontur der Komponente des Luftfahrzeugs angepasst ist, an der angeordnet zu werden das Kohlefasermaterial eingerichtet ist. Heizelemente mit derartigen Kohlefaser-Gittergewebe-Elementen sind aufgrund der Gitterstruktur besonders vorteilhaft in der Herstellung.

Besonders bevorzugt ist eine Variante, bei der das Kohlefaser-Gittergewebe-Element eine Hinterspritzschicht aufweist, die mindestens einen Kunststoff, vorzugsweise ein Polyamid (insbesondere ein Polyphthalamid) und/oder Polyarylamid umfasst. Die Hinterspritzschicht dient dabei vorzugsweise einer Einfassung und elektrischen Isolierung der elektrischen Kontakte. Vorteilhaft ist eine Variante, bei der die Hinterspritzschicht (mindestens) an einer der Komponente abgewandten Seite angeordnet ist.

Die elektrische Isolationsschicht auf dem Kohlefaser-Gittergewebe-Element ist vorzugsweise ein in mindestens einige der Gitterzwischenräume (also Löcher der Gitterstruktur) eingreifender Überzug. Sie kann vorzugsweise mittels eines Wirbelsinterverfahrens und/oder einer chemischen Gasphasenabscheidung hergestellt sein (für die in der Fachsprache auch die englische Bezeichnung "chemical vapour deposition" (CVD) verwendet wird). Das Eingreifen in die Löcher gewährleistet einen sicher isolierenden und belastbaren, nachhaltig anhaftenden Überzug. Analog erfolgt das Aufbringen der elektrischen Isolationsschicht gemäß einer vorteilhaften Ausführungsform eines erfindungsgemäßen (Herstellungs-)Verfahrens mittels Wirbelsinterns und/oder chemischer Gasphasenabscheidung.

Ein erfindungsgemäßes Heizgerät dient einer Flugenteisung von Luftfahrzeugen. Es umfasst eine Mehrzahl von Heizelementen gemäß einem der vorhergehenden Ansprüchen, die (miteinander) in Serie oder (zueinander) parallel geschaltet sind. Mit einem derartigen Heizgerät kann an verschiedenen Positionen eines Luftfahrzeugs eine Flugenteisung mit den oben genannten Vorteilen der Heizelemente realisiert werden.

Ein erfindungsgemäßes (Enteisungs-)Verfahren dient einem Enteisen einer Komponente eines Luftfahrzeugs. Es umfasst ein Herstellen einer elektrischen Verbindung von elektrischen Kontakten eines Heizelements mit einem elektrischen Leitungssystem, wobei das Heizelement ein mit mindestens einer Isolationsschicht überzogenes Kohlefasermaterial umfasst und an der Komponente des Luftfahrzeugs angeordnet ist.

Ein derartiges Enteisungsverfahren ist einfach zu steuern. Im Gegensatz zur thermischen Enteisung kann es zudem auch am Boden angewandt werden, ohne dass die Gefahr besteht, dass dem Triebwerk Startleistung entzogen oder dass das Umgebungsmaterial aufgrund fehlenden kühlenden Flugwindes geschädigt wird.

Das Heizelement kann dabei so an der Komponente angeordnet sein, dass es sie berührt, es kann aber auch in einem Abstand zur Komponente positioniert sein. Heizelement und Komponente sind in diesem Falle jedoch in einem so geringen Abstand zueinander angeordnet, dass das Heizelement mindestens einen Abschnitt der Komponente erwärmen kann, beispielsweise in einem Abstand von weniger als 3 cm, bevorzugter in einem Abstand kleiner als 1,5 cm.

Insbesondere kann das Heizelement, das gemäß einem erfindungsgemäßen (Enteisungs-)Verfahren mit einem elektrischen Leitungssystem elektrisch verbunden wird, entsprechend einer in dieser Schrift genannten Ausführungsform eines erfindungsgemäßen Heizelements ausgebildet sein und/oder es kann mittels einer Ausführungsform eines in dieser Schrift genannten erfindungsgemäßen Herstellungsverfahrens hergestellt worden sein.

Insbesondere ist das Heizelement gemäß einer vorteilhaften Ausführungsform eines erfindungsgemäßen Enteisungsverfahrens in einem (positiven) Abstand zur Komponente an diese angesetzt, wobei der Abstand vorzugsweise mittels mindestens eines elektrisch isolierenden Distanzhalters bewirkt wird.

Im Folgenden werden Merkmale bevorzugter Ausführungsbeispiele der Erfindung anhand von Zeichnungen näher erläutert. Es versteht sich, dass die schematisch dargestellten einzelnen Elemente und Komponenten auch anders kombiniert und/oder ausgebildet sein können als gezeigt und dass die vorliegende Erfindung nicht auf dargestellte Merkmale beschränkt ist.

Es zeigen schematisch:
- Figur 1:: ein Blockdiagramm eines ersten exemplarischen (Herstellungs-)Verfahrens gemäß der vorliegenden Erfindung;
- Figur 2:: eine perspektivische Ansicht eines ersten beispielhaften Heizelements gemäß der vorliegenden Erfindung;
- Figur 3:: ein an einer Komponente angeordnetes Heizelement gemäß einer exemplarischen Ausführungsform der vorliegenden Erfindung im Querschnitt.
- Figur 4:: ein Blockdiagramm eines zweiten exemplarischen (Herstellungs-)Verfahrens gemäß der vorliegenden Erfindung; und
- Figur 5:: eine perspektivische Ansicht eines beispielhaften zweiten Heizelements gemäß der vorliegenden Erfindung.

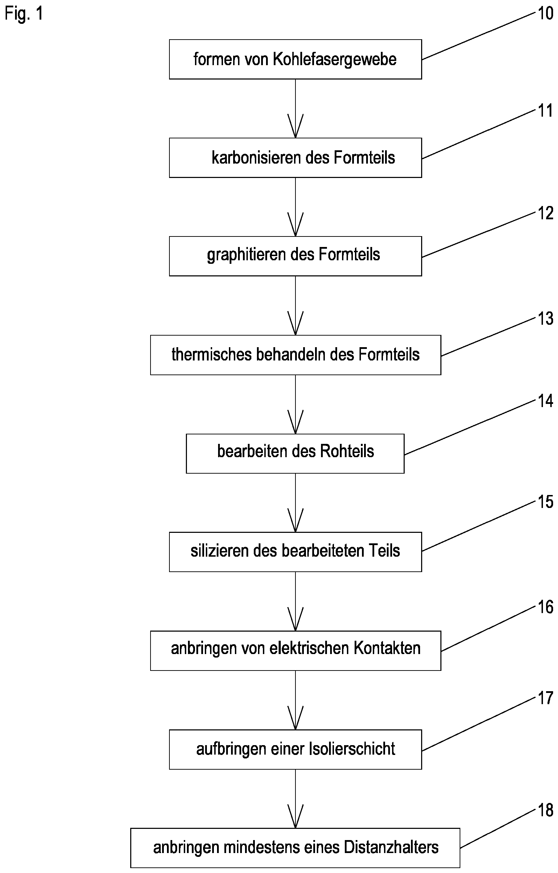

In Figur 1 ist ein Blockdiagramm eines ersten exemplarischen (Herstellungs-)Verfahrens gemäß einer Ausführungsform der vorliegenden Erfindung dargestellt; es versteht sich, dass andere Ausführungsformen eines erfindungsgemäßen Herstellungsverfahrens nicht alle dargestellten Schritte umfassen müssen und/oder dass die Reihenfolge der Schritte eine andere sein kann als die gezeigte:
In einem Schritt 10 wird zunächst ein (vorzugsweise mehrlagiges) Kohlefasergewebe in eine Form gebracht, beispielsweise an eine Kontur einer Komponente eines Luftfahrzeugs angepasst. Das dadurch entstandene Formteil wird alsdann in einem Schritt 11 karbonisiert sowie in einem Schritt 12 graphitiert; damit wird vorzugsweise ein Rohteil aus kohlenstofffaserverstärktem Kohlenstoff großer mechanischer Festigkeit erzeugt.

In einem Schritt 13 wird das Formteil thermisch behandelt (kalziniert). So können im Material enthaltene Hilfsmittel eliminiert und das Formteil insgesamt kompaktiert werden.

Das durch die vorangegangenen Schritte entstandene Rohteil wird in einem Schritt 14 bearbeitet. Die Bearbeitung kann dabei mechanisch und/oder plasmatechnisch erfolgen und/oder eine Behandlung mit Laser und/oder Wasserstrahltechnik umfassen. Sie dient insbesondere einer Vorbereitung der Oberfläche des Rohteils für Schritt 15, in dem das bearbeitete Rohteil siliziert wird. Dabei wird vorzugsweise flüssiges Silizium auf mindestens einen Teil einer Oberfläche des bearbeiteten Rohteils aufgebracht. Das Silizium reagiert mit dem Kohlenstoff des Kohlefasermaterials zu Siliziumkarbid (SiC), das eine Schicht auf dem Kohlefasermaterial ausbildet. Vorzugsweise bedeckt diese Schicht auch gegebenenfalls vorhandene Schnittflächen des Kohlefasermaterials.

In Schritt 16 werden elektrische Kontakte an dem Kohlefasermaterial angebracht. Diese Kontakte dienen einem Anschluss an ein elektrisches Leitungssystem; dadurch wird ein Hindurchleiten von Strom durch das Kohlefasermaterial und damit ein Erhitzen des Heizelements ermöglicht.

Die Siliziumkarbid-Schicht bildet eine Grundlage für eine elektrische Isolationsschicht aus einem oder mehreren keramischen Grundstoff(en), die in Schritt 17 aufgetragen wird; insbesondere kann die elektrische Isolationsschicht beispielsweise Aluminiumoxid (Al₂O₃) umfassen. Das Auftragen erfolgt dabei vorzugsweise durch Aufbringen einer Streichmasse: Dadurch kann eine Delamination verhindert werden, die hingegen bei einem Aufspritzen aufgrund einer hohen Oberflächenspannung des aufgespritzten Materials eintreten kann.

In Schritt 18 wird mindestens ein Distanzhalter angebracht, der nach einem Anordnen des Heizelements an der Komponente an mindestens einem Bauteil des Luftfahrzeugs anliegen und einen (positiven) Abstand zwischen dem beschichteten Kohlefasermaterial und dem mindestens einen Bauteil gewährleisten soll. Der mindestens eine Distanzhalter ist vorzugsweise aus einem elektrisch isolierenden Material und kann z.B. als Folie entlang einem Streifen und/oder in Form einer oder mehrerer einzelner Noppen aufgebracht sein. Geeignete Werkstoffe für den mindestens einen Distanzhalter sind beispielsweise Aluminiumoxid (Al₂O₃), ein Polyamid und/oder ein Polyimid (z.B. Kapton).

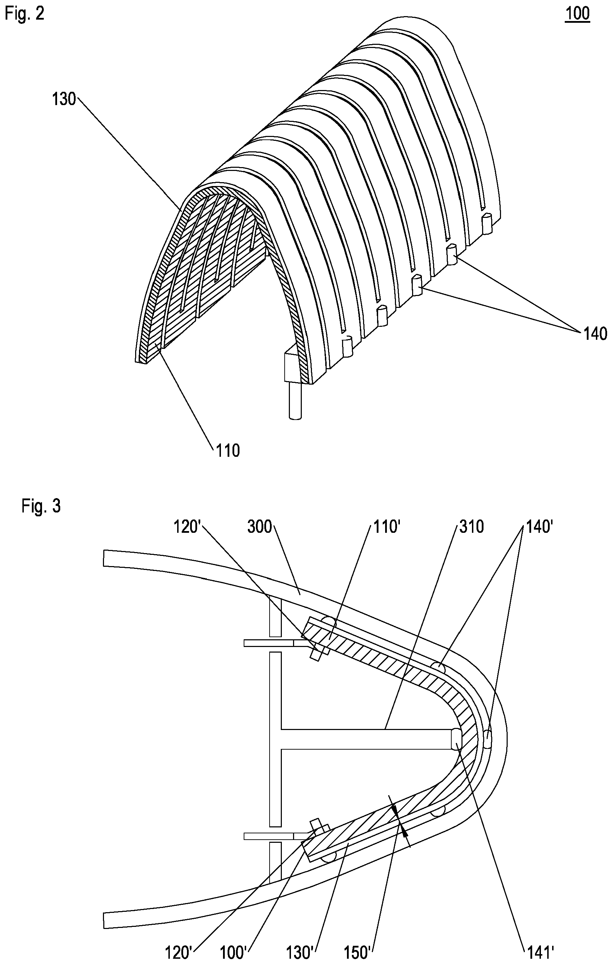

Figur 2 zeigt ein Heizelement 100 gemäß einer Ausführungsform der vorliegenden Erfindung, wie es beispielsweise mittels eines in der Figur 1 dargestellten erfindungsgemäßen Verfahrens hergestellt worden sein könnte.

Das Heizelement 100 umfasst Kohlefasermaterial 110, das entsprechend seiner Bestimmung geformt ist; im vorliegenden Fall ist das Kohlefasermaterial 110 an die Kontur einer Flügelvorderkante angepasst, an der das Heizelement angeordnet werden soll, um für eine Flugenteisung der Komponente verwendet zu werden.

Im dargestellten Ausführungsbeispiel ist das Kohlefasermaterial streifenartig entlang einer in eine Mehrzahl von Rippen gewundenen Bahn ausbildet. Vorzugsweise umfasst das Kohlefasermaterial 110 ein mehrlagiges, karbonisiertes und graphitiertes Kohlefasergewebe, insbesondere einen kohlenstofffaserverstärkten Kohlenstoff. Ein derartiges Material weist eine besonders hohe mechanische Festigkeit und Formstabilität auf.

Das dargestellte Heizelement 100 weist zudem elektrische Kontakte 120 zum Anschluss an ein elektrisches Leitungssystem sowie mindestens eine Isolationsschicht 130 zur elektrischen Isolierung auf; von den elektrischen Kontakten ist in der Figur nur der Kontakt 120 an einem in der Darstellung vorderen Ende der gewundenen Bahn zu sehen; ein weiterer, am anderen Ende der gewundenen Bahn befindlicher elektrischer Kontakt ist verdeckt.

Die mindestens eine elektrische Isolationsschicht dient einer elektrischen Isolierung des Heizelements 100 gegenüber einer Komponente des Luftfahrzeugs, an der das das Kohlefasermaterial bei bestimmungsgemäßer Verwendung angeordnet ist. Die elektrische Isolationsschicht kann beispielsweise Aluminiumoxid, Bornitrid, Siliziumkarbid, Zirkoniumdiborid und/oder Hafniumdiborid enthalten.

Weiterhin weist das Heizelement 100 eine Mehrzahl von Distanzhaltern 140 auf, die vorzugsweise aus einem elektrisch isolierenden Material gebildet sind und im dargestellten Fall dazu eingerichtet sind, nach einem Anordnen des Heizelements an der Komponente an dieser anzuliegen und einen (positiven) Abstand zwischen dem beschichteten Kohlefasermaterial und der Komponente zu gewährleisten.

In Figur 3 ist in einem Querschnitt ein Heizelement 100' mit einem Kohlefasermaterial 110' dargestellt, das an einer Komponente 300 eines Luftfahrzeugs angeordnet ist; die Komponente 300 ist dabei im gezeigten Beispiel eine Flügelvorderkante eines Flugzeugs.

Das Kohlefasermaterial 110' umfasst vorzugsweise einen mehrlagigen kohlefaserverstärkten Kohlenstoff. Das Heizelement 100' weist zwei elektrische Kontakte 120' auf, mit denen das Kohlefasermaterial 110' an ein elektrisches Leitungssystem angeschlossen werden kann. Mittels eines Hindurchleitens von elektrischem Strom kann das Heizelement erhitzt werden. An einer der Komponente 300 zugewandten Oberfläche des Kohlefasermaterials 110' umfasst das Heizelement eine elektrische Isolationsschicht 130', die das Kohlefasermaterial gegenüber der Komponente elektrisch isoliert.

Darüber hinaus umfasst das Heizelement 100' elektrisch isolierende Distanzhalter 140', die an der Komponente 300 anliegen und einen Abstand 150' zwischen dem beschichteten Kohlefasermaterial und der Komponente 300 gewährleisten. Dadurch kann die elektrische Isolierung auch bei dünner elektrischer Isolationsschicht 130' verbessert und zudem ein Zwischenraum zur Luftzirkulation geschaffen werden. Der Abstand 150 liegt vorzugsweise in einem Bereich von 0,1 cm bis 3 cm, bevorzugter in einem Bereich von 0,3 cm bis 1,5 cm.

Weiterhin weist das Heizelement 100' einen Distanzhalter 141' auf, der an einem Bauteil 310 des Luftfahrzeugs anliegt und das beschichtete Kohlefasermaterial in einem (durch eine Dicke des Distanzhalters 141' gegebenen) Abstand vom Bauteil 310 hält. Der Distanzhalter dient insbesondere einer Fixierung des Heizelements mittels einer Abstützung an dem Bauteil 310' und zudem einer elektrischen und vorzugsweise auch thermischen Isolierung des Kohlefasermaterials gegenüber dem Bauteil 310.

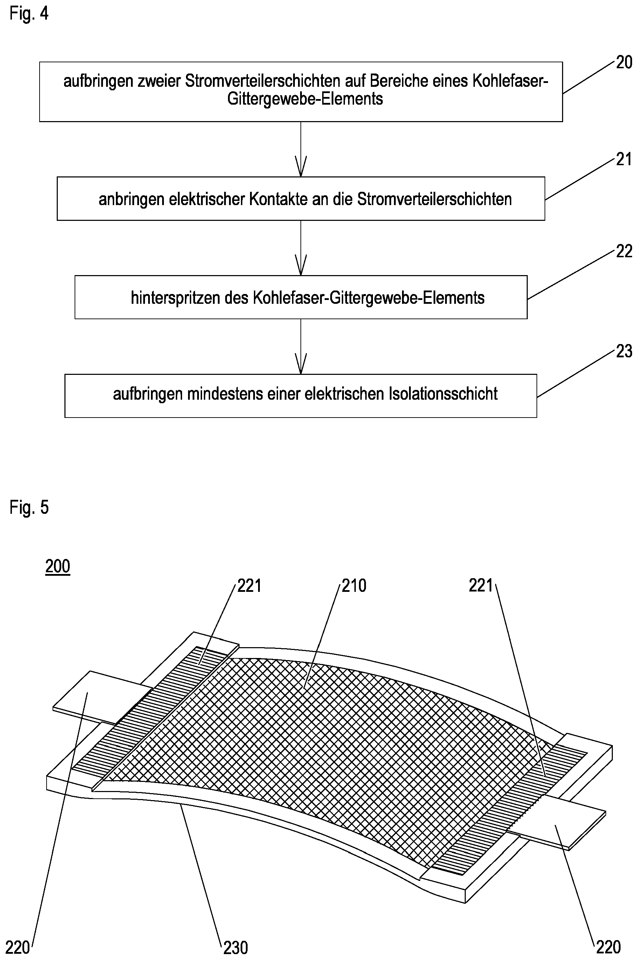

Figur 4 zeigt ein Blockdiagramm eines zweiten exemplarischen (Herstellungs-)Verfahrens gemäß einer beispielhaften Ausführungsform der vorliegenden Erfindung; es versteht sich, dass andere Ausführungsformen eines erfindungsgemäßen Herstellungsverfahrens nicht alle dargestellten Schritte umfassen müssen und/oder dass die Reihenfolge der Schritte eine andere sein kann als die gezeigte.

In einem Schritt 20 werden zwei Stromverteilerschichten je auf einen lokalen Bereich eines Kohlefasermaterials in Form eines Kohlefaser-Gittergewebe-Elements aufgebracht. Das Kohlefaser-Gittergewebe-Element weist dabei vorzugsweise eine zwei- oder dreidimensionale Formstruktur auf, die beispielsweise an eine Kontur einer Komponente mindestens lokal angepasst sein kann, an der anzuordnen das Heizelement vorgesehen ist. Die aufgebrachten Stromverteilerschichten können beispielsweise jeweils ein Metall umfassen, z.B. Kupfer. Insbesondere kann beispielsweise an zwei gegenüberliegenden Seiten des Kohlefaser-Gittergewebe-Elements jeweils eine solche Stromverteilerschicht aufgebracht werden.

In einem Schritt 21 werden elektrische Kontakte an die Stromverteilerschichten angebracht. In Schritt 22 wird das Kohlefaser-Gittergewebe-Element mindestens in einem Bereich des Kohlefaser-Gittergewebe-Elements mit einem elektrisch isolierenden Material hinterspritzt; dadurch werden die elektrische Kontakte an dem Kohlefaser-Gittergewebe-Element eingefasst und elektrisch isoliert. Das elektrisch isolierende Material ist vorzugsweise ein Kunststoff wie z.B. ein Polyamid (z.B. ein Polyphthalamid) oder Polyarylamid.

In Schritt 23 wird eine elektrische Isolationsschicht auf das Kohlefaser-Gittergewebe-Element aufgebracht. Das Aufbringen kann mittels eines Wirbelsinterverfahrens und/oder mit einer chemischen Gasphasenabscheidung erfolgen. Die derart aufgebrachte Isolationsschicht ist erfindungsgemäß gasdicht; dadurch kann ein besonders guter Wärmeübergang erzielt werden. Geeignete Materialien der elektrischen Isolationsschicht sind z.B. Bornitrid (BN), Siliziumkarbid (SiC), Zirkoniumdiborid (ZrB₂) und/oder Hafniumdiborid (HfB₂).

In Figur 5 ist ein Heizelement 200 gemäß einer Ausführungsform der vorliegenden Erfindung dargestellt, wie es z.B. mittels eines in der Figur 4 gezeigten Verfahrens hergestellt worden sein könnte: Das Heizelement umfasst ein Kohlefasermaterial 210 in Form eines Kohlefaser-Gittergewebe-Elements. An zwei gegenüberliegenden Seiten des Kohlefaser-Gittergewebe-Elements sind jeweils Stromverteilerschichten 221 aufgebracht, die beispielsweise Kupfer enthalten können. Die Stromverteilerschichten 221 sind mit elektrischen Kontakten 220 des Heizelements 200 verbunden; diese sind dazu eingerichtet, an ein elektrisches Leitungssystem angeschlossen zu werden. Mittels durch das Kohlefaser-Gittergewebe-Element hindurchfließenden Stroms kann das Heizelement dann aufgeheizt werden, so dass es eine Komponente eines Luftfahrzeugs, an der es angeordnet wird, enteisen kann. Die Kontakte 220 sind vorzugsweise mittels eines hinterspritzten Kunststoffs eingefasst und elektrisch isoliert.

Das Heizelement 200 weist zudem mindestens eine elektrische Isolationsschicht 230 auf, mit der das Heizelement insbesondere gegenüber der Komponente des Luftfahrzeugs (an einer ihr zugewandten Fläche) elektrisch isoliert ist. Die mindestens eine elektrische Isolationsschicht ist vorzugsweise ein in die Gitterstruktur des Kohlefaser-Gittergewebe-Elements, insbesondere in darin ausgebildete Gitterzwischenräume eingreifender Überzug. Sie kann beispielsweise mittels eines Wirbelsinterverfahrens und/oder mit einer chemischen Gasphasenabscheidung aufgebracht worden sein.

### Bezugszeichen

- 10 - 23: verschiedene Verfahrensschritte

- 100, 100': Heizelement
- 110, 110': Kohlefasermaterial
- 120, 120': elektrischer Kontakt
- 130, 130': elektrische Isolationsschicht
- 140, 140', 141': Distanzhalter
- 150': Abstand

- 200: Heizelement
- 210: Kohlefasermaterial
- 220: elektrischer Kontakt
- 221: Stromverteilerschicht
- 230: elektrische Isolationsschicht

- 300: Komponente eines Luftfahrzeugs
- 310: Bauteil eines Luftfahrzeugs

## Patentansprüche

1. Heizelement (100, 100', 200) zur Flugenteisung von Luftfahrzeugen, das umfasst:
ein Kohlefasermaterial (110, 110', 210), das dazu eingerichtet ist, an einer Komponente (300) eines Luftfahrzeugs angeordnet zu werden,
wobei das Kohlefasermaterial mindestens zwei elektrische Kontakte (120, 120', 220) zum Anschluss an ein elektrisches Leitungssystem sowie mindestens eine Isolationsschicht (130, 130', 230) zur elektrischen Isolierung aufweist, **dadurch gekennzeichnet, dass** die mindestens eine Isolationsschicht (130, 130', 230) gasdicht ist.

2. Heizelement gemäß Anspruch 1, wobei die mindestens eine Isolationsschicht Aluminiumoxid, Bornitrid, Siliziumkarbid, Zirkoniumdiborid und/oder Hafniumdiborid umfasst.

3. Heizelement gemäß einem der Ansprüche 1 und 2, das mindestens einen elektrisch isolierenden Distanzhalter (140, 140', 141) aufweist, der dazu eingerichtet ist, nach einem Anordnen des Heizelements an der Komponente an dieser und/oder mindestens anderen einem Bauteil (300, 310) des Luftfahrzeugs anzuliegen und eine Abstand (150') zwischen dem beschichteten Kohlefasermaterial und der Komponente bzw. dem mindestens einen Bauteil zu gewährleisten.

4. Heizelement gemäß Anspruch 3, bei dem der gewährleistete Abstand in einem Bereich von 0,1 cm bis 3 cm, bevorzugter in einem Bereich von 0,3 cm bis 1,5 cm liegt.

5. Heizelement gemäß einem der Ansprüche 3 oder 4, wobei der mindestens eine Distanzhalter (140, 140', 141') ein keramisches Material und/oder mindesten einen thermisch beständigen Kunststoff umfasst.

6. Heizelement gemäß einem der vorhergehenden Ansprüche, bei dem das Kohlefasermaterial mehrlagig, karbonisiert, graphitiert und/oder kalziniert ist.

7. Heizelement gemäß einem der vorhergehenden Ansprüche, wobei zwischen dem Kohlefasermaterial und der mindestens einen Isolationsschicht (130, 130', 230) zur elektrischen Isolierung eine Siliziumkarbidschicht angeordnet ist.

8. Heizelement gemäß einem der vorhergehenden Ansprüche, bei dem das Kohlefasermaterial (210) ein Kohlefaser-Gittergewebe-Element umfasst.

9. Heizelement gemäß Anspruch 7, bei dem das Kohlefaser-Gittergewebe-Element eine Hinterspritzschicht aufweist, die einen Kunststoff, vorzugsweise Polyarylamid und/oder ein Polyamid umfasst.

10. Heizgerät zur Flugenteisung von Luftfahrzeugen, das eine Mehrzahl von Heizelementen gemäß einem der vorhergehenden Ansprüche umfasst, die in Serie oder parallel geschaltet sind.

11. Verfahren zum Herstellen eines Heizelements zur Flugenteisung von Luftfahrzeugen, das ein Anbringen (17, 21) von elektrischen Kontakten an ein Kohlefasermaterial (110, 110', 210) und
ein Aufbringen (17, 23) einer gasdichten Isolationsschicht (130, 130', 230) auf das Kohlefasermaterial umfasst.

12. Verfahren gemäß Anspruch 11, das ein Karbonisieren, Graphitieren, Kalzinieren und/oder Silizieren des Kohlefasermaterials (110, 110', 210) umfasst.

13. Verfahren gemäß einem der Ansprüche 11 oder 12, wobei die Isolationsschicht (130, 130', 230) einen keramischen Grundstoff umfasst und als Streichmasse aufgebracht wird.

14. Verfahren gemäß einem der Ansprüche 11 oder 12, wobei das Aufbringen der Isolationsschicht mittels Wirbelsintern und/oder chemischer Gasphasenabscheidung erfolgt.

15. Verfahren zum Enteisen einer Komponente eines Luftfahrzeugs mittels des Heizelements gemäß Anspruch 1.

## Claims

1. Heating element (100, 100', 200) for in-flight de-icing of aircraft, comprising:
a carbon fibre material (110, 110', 210), which is designed for being arranged on a component (300) of an aircraft,
wherein the carbon fibre material comprises at least two electrical contacts (120, 120', 220) for connecting to an electrical wiring system and at least one insulation layer (130, 130', 230) for electrical insulation, **characterized in that** the at least one insulation layer (130, 130', 230) is gas-impermeable.

2. Heating element according to Claim 1, wherein the at least one insulation layer comprises aluminium oxide, boron nitride, silicon carbide, zirconium diboride and/or hafnium diboride.

3. Heating element according to either of Claims 1 and 2, comprising at least one electrically insulating spacer (140, 140', 141), which is designed to rest on the component and/or at least one other structural member (300, 310) of the aircraft after the heating element has been arranged on the component, and to ensure a spacing (150') between the coated carbon fibre material and the component or the at least one structural member.

4. Heating element according to Claim 3, in which the ensured spacing lies in a range from 0.1 cm to 3 cm, preferably in a range from 0.3 cm to 1.5 cm.

5. Heating element according to either of Claims 3 and 4, wherein the at least one spacer (140, 140', 141') comprises a ceramic material and/or at least one heat-resistant plastic.

6. Heating element according to one of the preceding claims, in which the carbon fibre material is multilayered, carbonized, graphitized and/or calcined.

7. Heating element according to one of the preceding claims, wherein a silicon carbide layer is arranged between the carbon fibre material and the at least one insulation layer (130, 130', 230) for electrical insulation.

8. Heating element according to one of the preceding claims, in which the carbon fibre material (210) comprises a carbon fibre/scrim element.

9. Heating element according to Claim 7, in which the carbon fibre/scrim element comprises an in-mould coating layer which comprises a plastic, preferably polyarylamide and/or a polyamide.

10. Heating device for in-flight de-icing of aircraft, comprising a plurality of heating elements according to one of the preceding claims which are connected in series or in parallel.

11. Method for producing a heating element for in-flight de-icing of aircraft, comprising attaching (17, 21) electrical contacts to a carbon fibre material (110, 110', 210) and applying (17, 23) a gas-impermeable insulation layer (130, 130', 230) to the carbon fibre material.

12. Method according to Claim 11, comprising carbonizing, graphitizing, calcining and/or siliconizing the carbon fibre material (110, 110', 210) .

13. Method according to either of Claims 11 and 12, wherein the insulation layer (130, 130', 230) comprises a ceramic basic material and is applied as a spread coating compound.

14. Method according to either of Claims 11 and 12, wherein the insulation layer is applied by means of fluidized bed coating and/or chemical vapour deposition.

15. Method for de-icing a component of an aircraft by means of the heating element according to Claim 1.

## Revendications

1. Élément chauffant (100, 100', 200) destiné au dégivrage en vol d'aéronefs, qui comprend :
un matériau à base de fibres de carbone (110, 110', 210), qui est conçu pour être disposé au niveau d'un composant (300) d'un aéronef,
le matériau à base de fibres de carbone possédant au moins deux contacts électriques (120, 120', 220) servant au raccordement à un système de lignes électrique ainsi qu'au moins une couche isolante (130, 130', 230) servant à l'isolation électrique, **caractérisé en ce que**
l'au moins une couche isolante (130, 130', 230) est hermétique aux gaz.

2. Élément chauffant selon la revendication 1, l'au moins une couche isolante comprenant de l'oxyde d'aluminium, du nitrure de bore, du carbure de silicium, du diborure de zirconium et/ou du diborure de hafnium.

3. Élément chauffant selon l'une des revendications 1 et 2, qui possède au moins une entretoise (140, 140', 141) électriquement isolante, laquelle est conçue pour, après un montage de l'élément chauffant au niveau du composant, reposer contre celui-ci et/ou au moins un autre élément structural (300, 310) de l'aéronef et garantir un écart (150') entre le matériau à base de fibres de carbone revêtu et le composant ou l'au moins un élément structural.

4. Élément chauffant selon la revendication 3, avec lequel l'écart garanti est compris dans une plage de 0,1 cm à 3 cm, de préférence dans une plage de 0,3 cm à 1,5 cm.

5. Élément chauffant selon l'une des revendications 3 ou 4, l'au moins une entretoise (140, 140', 141) comprenant un matériau céramique et/ou au moins une matière plastique thermiquement résistante.

6. Élément chauffant selon l'une des revendications précédentes, avec lequel le matériau à base de fibres de carbone est multicouche, carbonisé, graphité et/ou calciné.

7. Élément chauffant selon l'une des revendications précédentes, une couche en carbure de silicium étant disposée entre le matériau à base de fibres de carbone et l'au moins une couche isolante (130, 130', 230) en vue de réaliser l'isolation électrique.

8. Élément chauffant selon l'une des revendications précédentes, avec lequel le matériau à base de fibres de carbone (210) comprend un élément à structure en treillis de fibres de carbone.

9. Élément chauffant selon la revendication 7, avec lequel l'élément à structure en treillis de fibres de carbone possède une couche injectée sur l'arrière qui comprend une matière plastique, de préférence du polyarylamide et/ou du polyamide.

10. Appareil chauffant destiné au dégivrage en vol d'aéronefs, lequel comprend une pluralité d'éléments chauffants selon l'une des revendications précédentes qui sont branchés en série ou en parallèle.

11. Procédé de fabrication d'un élément chauffant destiné au dégivrage en vol d'aéronefs, lequel comprend un montage (17, 21) de contacts électriques sur un matériau à base de fibres de carbone (110, 110', 210) et
une application (17, 23) d'une couche isolante (130, 130', 230) hermétique aux gaz sur le matériau à base de fibres de carbone.

12. Procédé selon l'une des revendications 11, qui comprend une carbonisation, une graphitisation, une calcination et/ou une siliciumisation du matériau à base de fibres de carbone (110, 110', 210).

13. Procédé selon l'une des revendications 11 ou 12, la couche isolante (130, 130', 230) comprenant une matière première céramique et étant appliquée sous la forme d'une masse d'enduction.

14. Procédé selon l'une des revendications 11 ou 12, l'application de la couche isolante étant effectuée par bain fluidisé et/ou par dépôt chimique en phase gazeuse.

15. Procédé de dégivrage d'un composant d'un aéronef au moyen de l'élément chauffant selon la revendication 1.
